(19) Europäisches Patentamt
European Patent Office
Office européen des brevets

(11) **EP 4 067 994 A1**

(12) **EUROPEAN PATENT APPLICATION**
published in accordance with Art. 153(4) EPC

(43) Date of publication:
**05.10.2022 Bulletin 2022/40**

(21) Application number: **20892996.8**

(22) Date of filing: **25.11.2020**

(51) International Patent Classification (IPC):
*G03F 1/24* $^{(2012.01)}$

(52) Cooperative Patent Classification (CPC):
**G03F 1/24**

(86) International application number:
**PCT/JP2020/043889**

(87) International publication number:
**WO 2021/106954 (03.06.2021 Gazette 2021/22)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.11.2019 JP 2019214852**

(71) Applicant: **Toppan Photomask Co., Ltd.
Tokyo 108-0023 (JP)**

(72) Inventors:
• **NAKANO, Hideaki
Taito-ku, Tokyo 110-0016 (JP)**
• **GODA, Ayumi
Taito-ku, Tokyo 110-0016 (JP)**
• **ICHIKAWA, Kenjiro
Taito-ku, Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK BLANK AND REFLECTIVE PHOTOMASK**

(57) To provide a reflective photomask blank and a reflective photomask that suppress or reduce a shadowing effect of a reflective photomask for patterning transfer using a light having a wavelength in the extreme ultraviolet region as a light source and have resistance to hydrogen radicals. A reflective photomask blank (10) according to this embodiment is a reflective photomask blank used for manufacturing a reflective photomask for pattern transfer using an extreme ultraviolet light as a light source, and the reflective photomask blank has: a substrate (1); a reflective layer (2) containing a multi-layer film formed on the substrate (1); and an absorption layer (4) formed on the reflective layer (2), in which the absorption layer (4) is formed of a material containing tin (Sn) and oxygen (O) in the proportion of 50 at% or more in total, the atomic number ratio (O/Sn) of oxygen (O) to tin (Sn) in the absorption layer (4) exceeds 2.0, and the film thickness of the absorption layer (4) is within the range of 17 nm or more and 45 nm or less.

FIG. 1

EP 4 067 994 A1

**Description**

Technical Field

The present invention relates to a reflective photomask used in lithography using a light in the ultraviolet region as a light source and a reflective photomask blank for producing the same.

Background Art

In a production process for semiconductor devices, a demand for miniaturization by a photolithography technology has increased with the miniaturization of the semiconductor devices. In the photolithography, the minimum resolution dimension of a transfer pattern largely depends on the wavelength of an exposure light source, and the minimum resolution dimension can be made smaller as the wavelength is shorter. Therefore, as an exposure light source, a conventional ArF excimer laser light having a wavelength of 193 nm has been replaced with a light in an extreme ultraviolet (EUV) region having a wavelength of 13.5 nm.

Since the light in the EUV region is absorbed at a high ratio by most substances, a reflective photomask is used as a photomask for EUV exposure (EUV photomask) (see PTL 1, for example). PTL 1 discloses an EUV photomask obtained by forming a reflective layer containing a multi-layer film in which a molybdenum (Mo) layer and a silicon (Si) layer are alternately deposited on a glass substrate, forming a light absorption layer containing tantalum (Ta) as a main component on the reflective layer, and forming a pattern on the light absorption layer.

Further, in EUV lithography, a dioptric system utilizing light transmission cannot be used as described above, and therefore an optical system member of an exposure machine is not a lens but a reflective type (mirror). This poses a problem that an incident light and a reflected light on the reflective mask (EUV mask) cannot be designed to be on the same axis. In general, the EUV lithography uses a technique of making an EUV light incident by tilting the optical axis by 6° from the vertical direction of the EUV mask and guiding a reflected light reflected at an angle of -6° to a semiconductor substrate.

As described above, the optical axis is tilted via the mirror in the EUV lithography, which has sometimes posed a problem referred to as a so-called "shadowing effect" in which the EUV light incident on the EUV mask creates a shadow of a mask pattern (patterned light absorption layer) of the EUV mask.

In a current EUV mask blank, a film containing tantalum (Ta) as the main component and having a film thickness of 60 to 90 nm is used as the light absorption layer. When a pattern transfer is exposed with the EUV mask manufactured using the mask blank, there is a risk that the exposure causes a contrast reduction in an edge part which is shadowed by the mask pattern, depending on the relationship between the incident direction of the EUV light and the direction of the mask pattern. This poses problems, such as an increase in the line edge roughness of the transfer pattern on the semiconductor substrate and inability to form the line width to a target dimension, and thus the transfer performance deteriorates in some cases.

Therefore, a reflective photomask blank has been studied in which tantalum (Ta) is changed to a material with high absorptivity (extinction coefficient) to the EUV light or a material with high absorptivity is added to tantalum (Ta) in the light absorption layer. For example, PTL 2 describes a reflective photomask blank in which a light absorption layer contains a material containing Ta in the proportion of 50 at% or more as the main component and further containing at least one element selected from Te, Sb, Pt, I, Bi, Ir, Os, W, Re, Sn, In, Po, Fe, Au, Hg, Ga, and Al.

Further, it is known that the mirror is contaminated with carbon, by-products of EUV generation (e.g. Sn), or the like. The accumulation of contaminants on the mirror reduces the reflectance of the mirror surface and reduces the throughput of lithography equipment. To address this problem, PTL 3 discloses a method for removing the contaminants from the mirror by generating hydrogen radicals in the equipment and reacting the hydrogen radicals with the contaminants.

However, it has not been studied in the reflective photomask blank described in PTL 2 that the light absorption layer has resistance to hydrogen radicals (hydrogen radical resistance). Therefore, the transfer pattern (mask pattern) formed on the light absorption layer cannot be stably maintained by the introduction into an EUV exposure apparatus, and as a result, there is a possibility that the transferability deteriorates.

Citation List

Patent Literature

PTL 1: JP 2011-176162 A

PTL 2: JP 2007-273678 A
PTL 3: JP 2011-530823 A

Summary of Invention

Technical Problem

Thus, it is an object of the present invention to provide a reflective photomask blank and a reflective photomask which suppress or reduce the shadowing effect of a reflective photomask for patterning transfer using a light having a wavelength in the extreme ultraviolet region as a light source and have resistance to hydrogen radicals.

Solution to Problem

In order to solve the above-described problems, a reflective photomask blank according to one aspect of the present invention is a reflective photomask blank for manufacturing a reflective photomask for pattern transfer using an extreme ultraviolet light as a light source, and the reflective photomask blank has: a substrate; a reflective layer containing a multi-layer film formed on the substrate; and an absorption layer formed on the reflective layer, in which the absorption layer is formed of a material containing tin (Sn) and oxygen (O) in the proportion of 50 at% or more in total, the atomic number ratio (O/Sn) of oxygen (O) to tin (Sn) in the absorption layer exceeds 2.0, and the film thickness of the absorption layer is within the range of 17 nm or more and 45 nm or less.
A reflective photomask according to one aspect of the present invention has: a substrate; a reflective layer containing a multi-layer film formed on the substrate; and an absorption pattern layer formed on the reflective layer, containing a material containing tin (Sn) and oxygen (O) in the proportion of 50 at% or more in total and having an atomic number ratio of oxygen (O) to tin (Sn) (O/Sn) of more than 2.0, on which a pattern is formed, in which the film thickness of the absorption pattern layer is within the range of 17 nm or more and 45 nm or less.

Advantageous Effects of Invention

According to one aspect of the present invention, a reflective photomask can be expected, in which the transfer performance to a semiconductor substrate in patterning using a light having a wavelength in the extreme ultraviolet region as a light source is improved and which can be used even in a hydrogen radical environment. More specifically, the reflective photomask blank and the reflective photomask according to one aspect of the present invention suppress or reduce the shadowing effect of the reflective photomask for patterning transfer using a light having a wavelength in the extreme ultraviolet region as a light source and have resistance to hydrogen radicals.

Brief Description of Drawings

FIG. 1 is a schematic cross-sectional view illustrating the structure of a reflective photomask blank according to an embodiment of the present invention;
FIG. 2 is a schematic cross-sectional view illustrating the structure of a reflective photomask according to the embodiment of the present invention;
FIG. 3 is a graph showing the optical constants of each metal material at the wavelength of an EUV light;
FIG. 4 is a schematic cross-sectional view illustrating the structure of a reflective photomask blank according to Examples of the present invention;
FIG. 5 is a schematic cross-sectional view illustrating a production process for a reflective photomask according to Examples of the present invention;
FIG. 6 is a schematic cross-sectional view illustrating a production process for the reflective photomask according to Examples of the present invention;
FIG. 7 is a schematic cross-sectional view illustrating a production process for the reflective photomask according to Examples of the present invention;
FIG. 8 is a schematic cross-sectional view illustrating the structure of the reflective photomask blank according to Examples of the present invention;
FIG. 9 is a schematic plan view illustrating the shape of a design pattern of the reflective photomask according to Examples of the present invention; and
FIG. 10 is a graph showing the reflectance of the reflective photomasks according to Examples and Comparative Examples of the present invention.

Description of Embodiments

An embodiment of the present invention will now be described below with reference to the drawings, but the present invention is not limited to the embodiment described below. In the embodiment described below, technically preferable limitations are made for implementing the present invention, but the limitations are not essential requirements of the present invention.

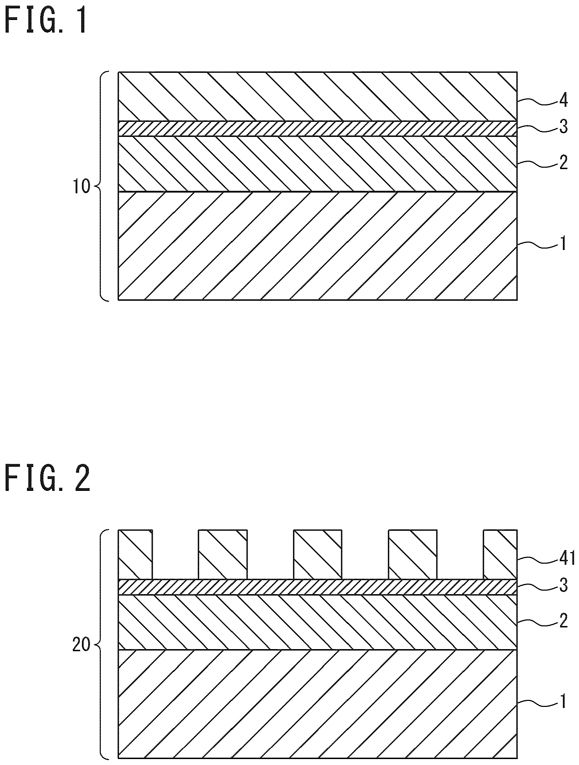

FIG. 1 is a schematic cross-sectional view illustrating the structure of a reflective photomask blank 10 according to the embodiment of the present invention. FIG. 2 is a schematic cross-sectional view illustrating the structure of a reflective photomask 20 according to the embodiment of the present invention. Herein, the reflective photomask 20 according to the embodiment of the present invention illustrated in FIG. 2 is formed by patterning an absorption layer 4 of the reflective photomask blank 10 according to the embodiment of the present invention illustrated in FIG. 1.

(Entire structure)

As illustrated in FIG. 1, the reflective photomask blank 10 according to the embodiment of the present invention includes a substrate 1, a reflective layer 2 formed on the substrate 1, a capping layer 3 formed on the reflective layer 2, and an absorption layer 4 formed on the capping layer 3.

(Substrate)

For the substrate 1 according to the embodiment of the present invention, a flat Si substrate, synthetic quartz substrate, or the like is usable for example. Further, a low thermal expansion glass to which titanium is added is usable for the substrate 1. However, the present invention is not limited to the above and any material having a small thermal expansion coefficient may be acceptable.

(Reflective layer)

The reflective layer 2 according to the embodiment of the present invention may be a layer reflecting an EUV light (extreme ultraviolet light), which is an exposure light, and may be a multi-layer reflective film containing a combination of materials having greatly different refractive indices to the EUV light, for example. The reflective layer 2 including the multi-layer reflective film may be a layer formed by repeatedly depositing a layer containing a combination of Mo (molybdenum) and Si (silicon) or Mo (molybdenum) and Be (beryllium) by about 40 cycles, for example.

(Capping layer)

The capping layer 3 according to the embodiment of the present invention is formed of a material resistant to dry etching performed in forming a transfer pattern (mask pattern) on the absorption layer 4 and functions as an etching stopper to prevent damage to the reflective layer 2 in etching the absorption layer 4. The capping layer 3 is formed of Ru (ruthenium), for example. Herein, the capping layer 3 may not be formed depending on materials of the reflective layer 2 and the etching conditions. Although not illustrated in the drawings, a back surface conductive film can be formed on the surface on which the reflective layer 2 is not formed of the substrate 1. The back surface conductive film is a film for fixing a reflective photomask 20 utilizing the principle of an electrostatic chuck when the reflective photomask 20 is installed in an exposure machine.

(Absorption layer)

As illustrated in FIG. 2, an absorption pattern (absorption pattern layer) 41 of the reflective photomask 20 is formed by removing a part of the absorption layer 4 of the reflective photomask blank 10, i.e., patterning the absorption layer 4. In the EUV lithography, the EUV light obliquely incidents and is reflected by the reflective layer 2, but the transfer performance onto a wafer (semiconductor substrate) sometimes deteriorates due to a shadowing effect in which the absorption pattern 41 interferes with an optical path. This deterioration of the transfer performance is reduced by reducing the thickness of the absorption layer 4 absorbing the EUV light. To reduce the thickness of the absorption layer 4, it is preferable to apply a material having higher absorptivity to the EUV light than that of a conventional material, i.e., a material having a high extinction coefficient k to a wavelength of 13.5 nm.

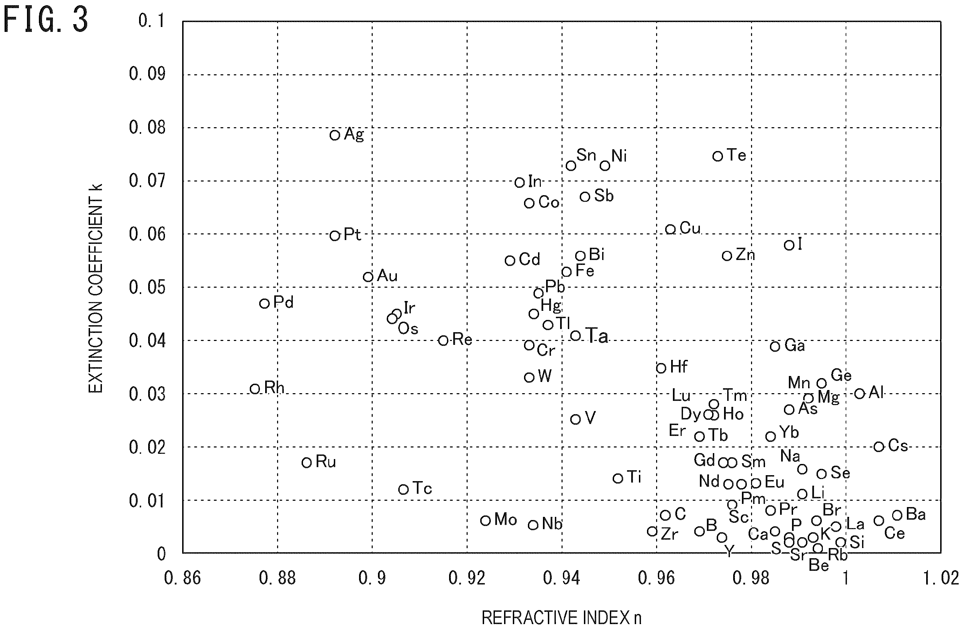

FIG. 3 is a graph showing the optical constants to the wavelength of 13.5 nm of the EUV light of each metal material. The horizontal axis of FIG. 3 represents the refractive index n and the vertical axis represents the extinction coefficient k. The extinction coefficient k of tantalum (Ta), which is a main material of the conventional absorption layer 4, is 0.041. Compound materials having a larger extinction coefficient k can reduce the thickness of the absorption layer 4 as compared with a conventional compound material. When the extinction coefficient k is 0.06 or more, the thickness of the absorption layer 4 can be sufficiently reduced and the shadowing effect can be reduced.

As materials satisfying a combination of the optical constants (nk value) described above, silver (Ag), platinum (Pt), indium (In), cobalt (Co), tin (Sn), nickel (Ni), and Tellurium (Te) are mentioned, for example, as illustrated in FIG. 3.

The reflective photomask blank 10 needs to be processable for patterning. Among the above-described materials, it is known that tin oxide can be subjected to dry etching with a chlorine-based gas. Therefore, the absorption layer 4 is formed of a material containing tin (Sn) and oxygen (O).

The reflective photomask 20 is exposed to a hydrogen radical environment, and therefore the reflective photomask 20 cannot withstand long-term use unless a light absorbing material having a high hydrogen radical resistance is used. In this embodiment, a material with a film reduction speed of 0.1 nm/s or less in a hydrogen radical environment in which the power is 1 kW and the hydrogen pressure is 0.36 mbar or less using microwave plasma is referred to as a high hydrogen radical resistant material.

Among the above-described materials, it is known that tin (Sn) alone has low resistance to hydrogen radicals, but the addition of oxygen increases the hydrogen radical resistance. Specifically, as shown in Table 1, the hydrogen radical resistance was confirmed in materials in which the atomic number ratio between tin (Sn) and oxygen (O) exceeds 1:2. This is considered to be because, when the atomic number ratio between tin (Sn) and oxygen (O) is 1:2 or less, all tin (Sn) bonds do not become tin oxides ($SnO_2$), and, to form tin oxide ($SnO_2$) throughout the film (throughout the absorption layer 4), the atomic number ratio needs to exceed 1:2. In a film reduction speed evaluation test shown in Table 1, the film reduction speed was repeatedly measured multiple times, and a case where the film reduction speed was 0.1 nm/s or less in all the measurements was evaluated as "∘", a case where the film reduction speed varied but the film reduction speed was 0.1 nm/s or less in more than half of the measurements was evaluated as "Δ", and a case where the film reduction speed exceeded 0.1 nm/s in all the measurements was evaluated as "×". In this embodiment, the evaluation of "Δ" has no problems in use, but the evaluation of "o" is more preferable in use. The above-described atomic number ratio (O/Sn ratio) is the result of measuring a material formed to have a film thickness of 1 μm by EDX (Energy Dispersive X-ray Analysis).

[Table 1]

| O/Sn ratio | 1.5 | 2 | 2.5 | 3 | 3.5 |
|---|---|---|---|---|---|
| Hydrogen radical resistance | × | Δ | ∘ | ∘ | ∘ |

The material containing tin (Sn) and oxygen (O) for forming the absorption layer 4 preferably contains oxygen (O) in a larger proportion than the proportion of stoichiometric tin oxide ($SnO_2$). More specifically, the atomic number ratio between tin (Sn) and oxygen (O) in the material constituting the absorption layer 4 preferably exceeds 1:2. In other words, the atomic number ratio (O/Sn) of oxygen (O) to tin (Sn) in the absorption layer 4 preferably exceeds 2.0. Due to the fact that the atomic number ratio between tin (Sn) and oxygen (O) in the material constituting the absorption layer 4 exceeds 1:2, sufficient hydrogen radical resistance can be imparted to the absorption layer 4.

When the atomic number ratio between tin (Sn) and oxygen (O) exceeds 1:3, a decrease in the EUV light absorptivity progresses, and therefore the atomic number ratio is preferably 1:3.5 or less and more preferably 1:3 or less.

Further, the material constituting the absorption layer 4 preferably contains tin (Sn) and oxygen (O) in the proportion of 50 at% or more in total. This is because, when the absorption layer 4 contains components other than tin (Sn) and oxygen (O), there is a possibility that both the EUV light absorptivity and the hydrogen radical resistance decrease, but, when the components other than tin (Sn) and oxygen (O) are contained in the proportion of less than 50 at%, the decrease in the EUV light absorptivity and the hydrogen radical resistance is very small, and the performance as the absorption layer 4 of the EUV mask hardly decreases.

As the materials other than tin (Sn) and oxygen (O), Ta, Pt, Te, Zr, Hf, Ti, W, Si, Cr, In, Pd, Ni, F, N, C, and H may be mixed, for example. More specifically, the absorption layer 4 may further contain, in addition to tin (Sn) and oxygen (O), one or more elements selected from the group consisting of Ta, Pt, Te, Zr, Hf, Ti, W, Si, Cr, In, Pd, Ni, F, N, C, and H.

For example, by mixing In in the absorption layer 4, electrical conductivity can be imparted to the film (absorption layer 4) while ensuring high absorptivity to the EUV light. This enables an increase in inspectability in a mask pattern inspection using a deep ultraviolet (DUV) light having a wavelength of 190 to 260 nm. Alternatively, when N or Hf is mixed in the absorption layer 4, the film quality can be made more amorphous. This enables an improvement of the roughness or the in-plane dimensional uniformity of an absorption layer pattern (mask pattern) after dry etching or the in-plane uniformity of a transferred image.

Although FIGS. 1 and 2 illustrate the absorption layer 4 having a single layer, the absorption layer 4 according to this embodiment is not limited thereto. The absorption layer 4 according to this embodiment may be one or more absorption layers, i.e., a multi-layer absorption layer, for example.

For the conventional absorption layer 4 of the EUV reflective photomask, the compound material containing Ta as the main component has been applied as described above. In this case, in order to obtain 1 or more in the optical density OD (Equation 1), which is an index showing the contrast of light intensity between the absorption layer 4 and the reflective layer 2, the film thickness of the absorption layer 4 needed to be 40 nm or more, and, in order to obtain 2 or more in the OD, the film thickness of the absorption layer 4 needed to be 70 nm or more. Although the extinction coefficient k of Ta is 0.041, the application of a compound material containing tin (Sn) and oxygen (O) and having an extinction coefficient k of 0.06 or more to the absorption layer 4 enables a decrease in the film thickness of the absorption layer 4 down to 17 nm when the OD is at least 1 or more and a decrease in the film thickness of the absorption layer 4 down to 45 nm or less when the OD is 2 or more by the Beer's law. However, when the film thickness of the absorption layer 4 exceeds 45 nm, the shadowing effect is almost the same as that of the conventional absorption layer 4 having a film thickness of 60 nm formed of the compound material containing Ta as the main component.

$$OD = -\log (Ra/Rm) \qquad (Equation\ 1)$$

The "Ra" above stands for the reflectance in the absorption layer 4 and the "Rm" above stands for the reflectance in the reflective layer 2 or in the reflective layer 2 and the capping layer 3.

Therefore, the film thickness of the absorption layer 4 according to the embodiment of the present invention is preferably 17 nm or more and 45 nm or less. More specifically, when the film thickness of the absorption layer 4 is within the range of 17 nm or more and 45 nm or less, the shadowing effect can be sufficiently reduced as compared with the conventional absorption layer 4 formed of the compound material containing Ta as the main component, and the transfer performance is improved. An optical density (OD) value is the contrast between the absorption layer 4 and the reflective layer 2. When the OD value is less than 1, a sufficient contrast cannot be obtained and the transfer performance tends to decrease.

The above-described "main component" refers to a component contained in the proportion of 50 at% or more based on the total number of atoms in the entire absorption layer.

Hereinafter, Examples of the reflective photomask blank and the reflective photomask according to the present invention are described.

[Example 1]

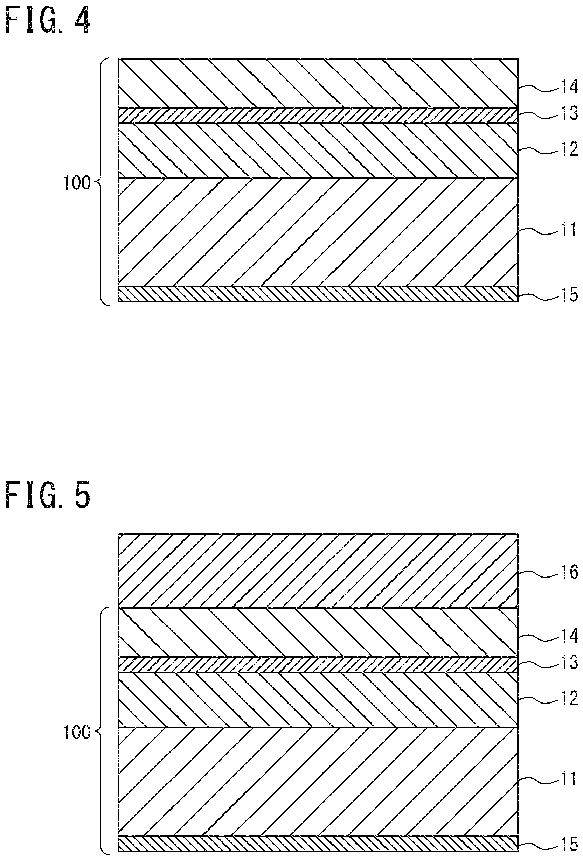

First, a method for manufacturing a reflective photomask blank 100 is described with reference to FIG. 4.

First, as illustrated in FIG. 4, a reflective layer 12 formed by depositing 40 multi-layer films containing a pair of silicon (Si) and molybdenum (Mo) on a synthetic quartz substrate 11 having a low thermal expansion property. The film thickness of the reflective layer 12 was set to 280 nm.

Next, a capping layer 13 composed of ruthenium (Ru) as an interlayer film was formed on the reflective layer 12 such that the film thickness was 3.5 nm.

Next, an absorption layer 14 containing tin (Sn) and oxygen (O) was formed on the capping layer 13 such that the film thickness was 26 nm. The atomic number ratio between tin (Sn) and oxygen (O) was 1:2.5 as measured by the EDX (Energy Dispersive X-ray Analysis). Further, the crystallinity of the absorption layer 14 was amorphous as measured by an XRD (X-ray diffractometer), although slight crystallinity was observed.

Next, a back surface conductive film 15 composed of chromium nitride (CrN) was formed on the surface on the side on which the reflective layer 12 was not formed of the substrate 11 with a thickness of 100 nm, thereby manufacturing the reflective photomask blank 100.

For the formation of each film (layer formation) on the substrate 11, a multi-source sputtering apparatus was used. The film thickness of each film was controlled by a sputtering time. The absorption layer 14 was formed such that the O/Sn ratio was 2.5 by controlling the amount of oxygen introduced into a chamber during sputtering by a reactive sputtering method.

Next, a method for manufacturing a reflective photomask 200 is described with reference to FIGS. 5 to 8.

First, a positive chemically amplified resist (SEBP9012: manufactured by Shin-Etsu Chemical Co., Ltd.) was applied by spin coating to have a film thickness of 120 nm on the absorption layer 14 of the reflective photomask blank 100 and baked at 110°C for 10 minutes to form a resist film 16 as illustrated in FIG. 5.

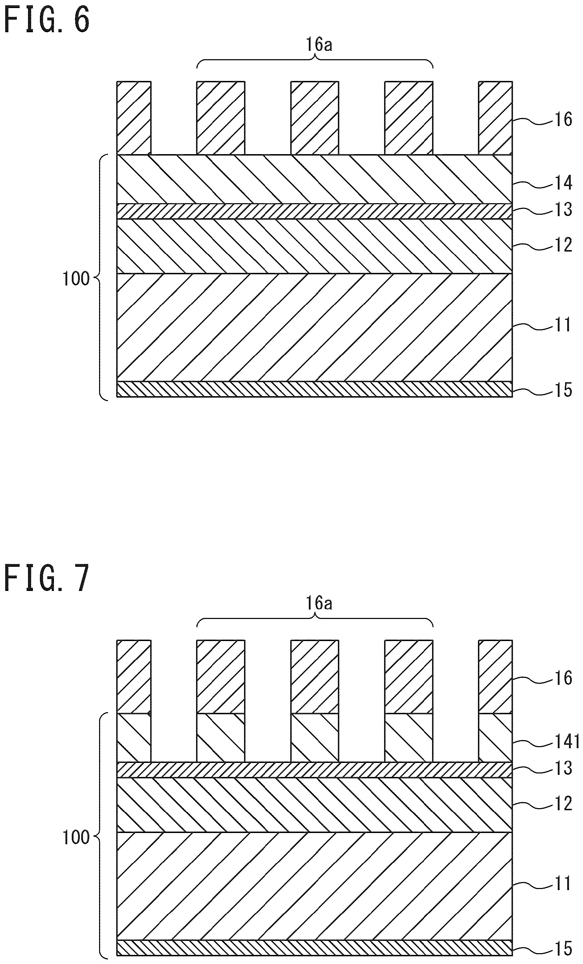

Next, a predetermined pattern was drawn on the resist film 16 using an electron beam lithography system (JBX3030: manufactured by JEOL Ltd.). Thereafter, prebaking treatment was applied at 110° for 10 minutes, and then spray-development was performed using a spray-development machine (SFG3000: manufactured by SIGMAMELTEC LTD.). Thus, a resist pattern 16a was formed as illustrated in FIG. 6.

Next, the absorption layer 14 was patterned by dry etching mainly containing a chlorine gas using the resist pattern 16a as an etching mask. Thus, an absorption pattern (absorption pattern layer) 141 was formed on the absorption layer 14 as illustrated in FIG. 7.

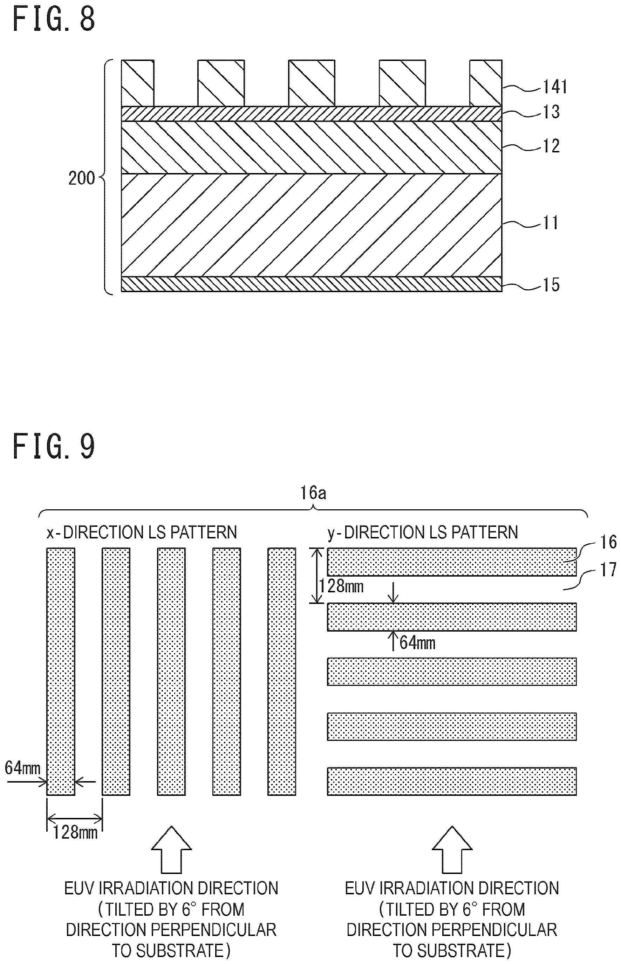

Next, the resist pattern 16a was peeled off, thereby manufacturing the reflective photomask 200 of this example as illustrated in FIG. 8. In this example, the absorption pattern 141 formed on the absorption layer 14 contains an LS (line and space) pattern with a line width of 64nm, an LS pattern with a line width of 200 nm for measuring the film thickness of an absorption layer using AFM, and 4 mm square absorption layer removed parts for EUV reflectance measurement on the reflective photomask 200 for transfer evaluation. In this example, the LS pattern with a line width of 64 nm was designed in each of the x-direction and the y-direction as illustrated in FIG. 9 such that the effect of the shadowing effect by EUV irradiation was able to be easily viewed.

[Example 2]

The absorption layer 14 was formed such that the atomic number ratio between tin (Sn) and oxygen (O) in the absorption layer 14 was 1:2.5, the total content of tin (Sn) and oxygen (O) was 70 at% of the entire absorption layer 14, and Ta was contained in the proportion of the remaining 30 at%. The absorption layer 14 was formed to have a film thickness of 26 nm. The reflective photomask blank 100 and the reflective photomask 200 of Example 2 were manufactured in the same manner as in Example 1, except for the formation of the absorption layer 14.

[Example 3]

The absorption layer 14 was formed such that the atomic number ratio between tin (Sn) and oxygen (O) in the absorption layer 14 was 1:2.5, the total content of tin (Sn) and oxygen (O) was 70 at% of the entire absorption layer 14, and In was contained in the proportion of the remaining 30 at%. The absorption layer 14 was formed to have a film thickness of 26 nm. The reflective photomask blank 100 and the reflective photomask 200 of Example 3 were manufactured in the same manner as in Example 1, except for the film formation of the absorption layer 14.

[Comparative Example 1]

The absorption layer 14 was formed such that the atomic number ratio between tin (Sn) and oxygen (O) in the absorption layer 14 was 1:1.5 and the film thickness of the absorption layer 14 was 26 nm. The reflective photomask blank 100 and the reflective photomask 200 of Comparative Example 1 were manufactured in the same manner as in Example 1, except for the film formation of the absorption layer 14.

[Comparative Example 2]

The absorption layer 14 was formed such that the atomic number ratio between tin (Sn) and oxygen (O) in the absorption layer 14 was 1:2.5 and the film thickness of the absorption layer 14 was 15 nm. The reflective photomask blank 100 and the reflective photomask 200 of Comparative Example 2 were manufactured in the same manner as in Example 1, except for the film formation of the absorption layer 14.

[Comparative Example 3]

The absorption layer 14 was formed such that the atomic number ratio between tin (Sn) and oxygen (O) in the absorption layer 14 was 1:2.5, the total content of tin (Sn) and oxygen (O) was 30 at% of the entire absorption layer 14, and SiO was contained in the proportion of the remaining 70 at%. The absorption layer 14 was formed to have a film thickness of 26 nm. The reflective photomask blank 100 and the reflective photomask 200 of Comparative Example 3 were manufactured in the same manner as in Example 1, except for the film formation of the absorption layer 14.

Separately from Examples and Comparative Examples described above, a reflective photomask having a conventional tantalum (Ta)-based absorption layer was also compared as a reference example. Similar to Examples and Comparative Examples described above, the reflective photomask blank has a reflective layer formed by depositing 40 multi-layer films containing a pair of silicon (Si) and molybdenum (Mo) on a synthetic quartz substrate having a low thermal expansion property and a ruthenium (Ru) capping layer 13 having a film thickness of 3.5 nm, in which the absorption layer 14 formed on the capping layer 13 is a layer obtained by forming TaO into a film having a film thickness of 2 nm on TaN having a film thickness of 58 nm. Similar to Examples and Comparative Examples described above, one in which the absorption layer 14 was patterned was used for the evaluation.

In Examples and Comparative Examples described above, the film thickness of the absorption layer 14 was measured by a transmission electron microscope.

Hereinafter, evaluation items evaluated in Examples are described.

(Reflectance)

In Examples and Comparative Examples described above, the reflectance Ra in a region of the absorption pattern layer 141 of the manufactured reflective photomask 200 was measured by a reflectance measuring device using the EUV light. Thus, the OD values of the reflective photomasks 200 according to Examples and Comparative Examples were obtained.

(Hydrogen radical resistance)

The reflective photomask 200 manufactured by each of Examples and Comparative Examples was installed in a hydrogen radical environment in which the power is 1 kW and the hydrogen pressure is 0.36 mbar or less using microwave plasma. A change in the film thickness of the absorption layer 14 after hydrogen radical treatment was confirmed using an atomic force microscope (AFM). The measurement was performed with the LS pattern with a line width of 200 nm.

(Wafer exposure evaluation)

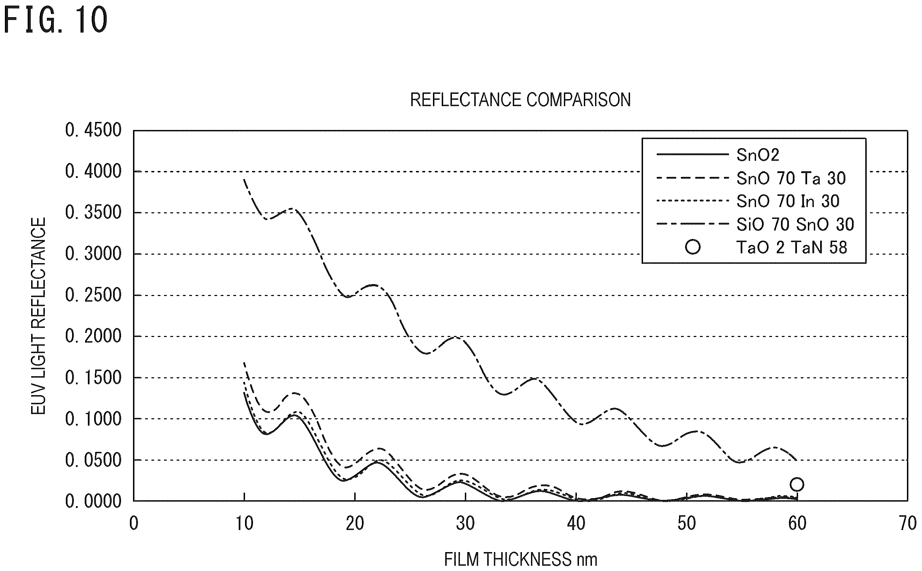

Using an EUV exposure apparatus (NXE3300B: manufactured by ASML), the absorption layer pattern 141 of the reflective mask 200 manufactured in each of Examples and Comparative Examples was transferred and exposed on a semiconductor wafer coated with an EUV positive chemically amplified resist. At this time, the exposure amount was adjusted such that the x-direction LS pattern illustrated in FIG. 9 was transferred as designed. Specifically, in this exposure test, the x-direction LS pattern (line width of 64 nm) illustrated in FIG. 9 was exposed to have a line width of 16 nm on the semiconductor wafer. A transferred resist pattern was observed and measured for the line width by an electron beam dimensional measuring machine, thereby confirming the resolution.
Theses evaluation results are shown in FIG. 10, Table 2, and Table 3.

[Table 2]

|  | Composition | Hydrogen radical resistance |
|---|---|---|
| Ex. 1 | Sn + O (1:2.5) | ○ |
| Ex. 2 | Sn + 0 (1:2.5) 70% Ta 30% | ○ |
| Ex. 3 | Sn + 0 (1:2.5) 70% In 30% | ○ |
| Comp. Ex. 1 | Sn + O (1:1.5) | × |
| Comp. Ex. 2 | Sn + 0 (1:2.b) | ○ |
| Comp. Ex. 3 | SiO 70% Sn + 0 (1:2.5) 30% | × |
| Reference Example | TaO 2 nm TaN 58 nm | ○ |

[Table 3]

|  | Composition | n | k | Film thickness | x-direction dimension (nm) | y-direction dimension (nm) | OD value | Determination |
|---|---|---|---|---|---|---|---|---|
| Ex. 1 | Sn + 0 (1:2.5) | 0.93 | 0.07 | 26 | 16 | 12.4 | 2.02 | ○ |
| Ex. 2 | Sn + 0 (1:2.5) 70% Ta 30% | 0.93 | 0.06 | 26 | 16 | 12.7 | 1.66 | ○ |

(continued)

|  | Composition | n | k | Film thickness | x-direction dimension (nm) | y-direction dimension (nm) | OD value | Determination |
|---|---|---|---|---|---|---|---|---|
| Ex. 3 | Sn + 0 (1:2.5) 70% In 30% | 0.93 | 0.07 | 26 | 16 | 12.4 | 1.93 | ◦ |
| Comp. Ex. 1 | Sn + 0 (1:1.5) | 0.93 | 0.07 | 26 | 16 | 12.4 | 2.02 | ◦ |
| Comp. Ex. 2 | Sn + 0 (1:2.5) | 0.93 | 0.07 | 15 | 16 | 13.9 | 0.8 | × |
| Comp. Ex. 3 | SiO 70% Sn + 0 (1:2.5) 30% | 0.95 | 0.02 | 26 | 16 | 14.7 | 0.55 | × |
| Reference Example | TaO 2 nm TaN 58 nm | - | - | 60 | 16 | 8.7 | 1.54 | ◦ |

FIG. 10 illustrates the EUV light reflectance of Examples and Comparative Examples. In FIG. 10, the reflective photomasks 200 including the absorption layers 14 having an atomic number ratio between tin (Sn) and oxygen (O) of 1:1.5 and 1:2.5, i.e., the absorption layers 14 of Example 1, Comparative Example 1, and Comparative Example 2, had no changes in the reflectance, and thus are summarized.

As illustrated in FIG. 10 and Table 2, as compared with the reflectance of the reflective photomask 200 including the conventional tantalum (Ta)-based absorption layer having a film thickness of 60 nm of 0.019 (OD = 1.54), the reflectance of the reflective photomasks 200 including the absorption layers 14 having a film thickness of 26 nm and formed of the material containing Sn and O, i.e., the absorption layers 14 of Example 1 and Comparative Example 1, is 0.006 (OD = 2.02), the reflectance of the reflective photomask 200 including the absorption layer 14 having a film thickness of 26 nm and formed of the material containing 30 at% of Ta, i.e., the absorption layer 14 of Example 2, is 0.014 (OD = 1.66), and the reflectance of the reflective photomask 200 including the absorption layer 14 having a film thickness of 26 nm and formed of the material containing 30 at% of In, i.e., the absorption layer 14 of Example 3, is 0.008 (OD = 1.93), and the reflectance of the reflective photomasks 200 was good.

On the other hand, in the case of the reflective photomask 200 including the absorption layer 14 formed of the material containing Sn and O and having a film thickness of 15 nm, i.e., the absorption layer 14 of Comparative Example 2, the reflectance is 0.102 (OD = 0.8), and the transfer performance deteriorated. The reflective photomask 200 including the absorption layer 14 in which the total content of Sn and O is 30 at% of the entire absorption layer 14 and SiO is contained in the proportion of the remaining 70 at%, i.e., the absorption layer 14 of Comparative Example 3, has a reflectance of 0.182 (OD = 0.55), resulting in a deterioration of transfer performance.

In this evaluation, a case where the OD value is 1 or more has no problem with the transfer performance, and was determined as "Pass".

Table 2 shows the results of the hydrogen radical resistance of the reflective photomasks 200 according to Examples and Comparative Examples. In Table 2, materials with a film reduction speed in the absorption layer 14 of 0.1 nm/s or less are indicated as "o" and materials with the film reduction speed of more than 0.1 nm/s are indicated as "×". Good hydrogen radical resistance was confirmed in the absorption layers 14 containing 70 at% or more of the material having an atomic number ratio between tin (Sn) and oxygen (O) of 1:2.5, i.e., the absorption layers 14 of Example 1 to Example 3 and Comparative Example 2. However, sufficient hydrogen radical resistance was not able to be obtained in the case of the absorption layer 14 formed of the material having an atomic number ratio between Sn and O of 1:1.5, i.e., the absorption layer 14 of Comparative Example 1, and in the case of the absorption layer 14 formed of the material in which, although the atomic number ratio between Sn and O is 1:2.5, the total content of Sn and O is 30 at% based on the entire absorption layer 14, i.e., the absorption layer 14 of Comparative Example 3.

Table 3 shows the mask properties and the resist pattern dimensions on the wafer of the reflective photomasks 200 of Examples and Comparative Examples.

In the reflective photomasks 200 including the absorption layers 14 having a film thickness of 26 nm and formed of the material containing Sn and O, i.e., the absorption layers 14 of Example 1 and Comparative Example 1, the reflective photomask 200 including the absorption layer 14 having a film thickness of 26 nm and formed of the material containing 30 at% of Ta, i.e., the absorption layer 14 of Example 2, and the reflective photomask 200 including the absorption layer 14 having a film thickness of 26 nm and formed of the material containing 30 at% of In, i.e., the absorption layer 14 of Example 3, the y-direction pattern dimensions were 12.4 nm, 12.7 nm, and 12.4 nm, respectively, which were better than the y-direction pattern dimension of 8.7 nm using the conventional Ta-based absorption layer.

In the reflective photomask 200 including the absorption layer 14 having a film thickness of 15 nm and formed of the material containing Sn and O, i.e., the absorption layer 14 of Comparative Example 2, and the reflective photomask 200 including the absorption layer 14 formed of the material in which the total content of Sn and O is 30 at% of the entire absorption layer 14, i.e., the absorption layer 14 of Comparative Example 3, the y-direction pattern dimensions were 13.9 nm and 14.7 nm, respectively, which were much better, but at least one of the reflectance and the hydrogen radical resistance was not sufficient as described above.

In Table 3, the reflective photomasks 200 which were able to suppress or reduce the shadowing effect are indicated as "∘" in the "Determination" column and the reflective photomasks 200 which were not able to sufficiently suppress or reduce the shadowing effect are indicated as "×" in the "Determination" column.

Thus, a result was obtained that, in the case of the photomask in which the material containing tin (Sn) and oxygen (O) having a larger content of oxygen than the content of the stoichiometric tin oxide is used for the absorption layer 14, both the optical density and the hydrogen radical resistance are good, the shadowing effect can be reduced, the long life time is obtained, and the transfer performance is high.

Industrial Applicability

The reflective photomask blank and the reflective photomask according to the present invention can be suitably used for forming a fine pattern by the EUV exposure in a production process for a semiconductor integrated circuit and the like.

Reference Signs List

| | |
|---|---|
| 1 | substrate |
| 2 | reflective layer |
| 3 | capping layer |
| 4 | absorption layer |
| 41 | absorption pattern (absorption pattern layer) |
| 10 | reflective photomask blank |
| 20 | reflective photomask |
| 11 | substrate |
| 12 | reflective layer |
| 13 | capping layer |
| 14 | absorption layer |
| 141 | absorption pattern (absorption pattern layer) |
| 15 | back surface conductive film |
| 16 | resist film |
| 16a | resist pattern |
| 17 | reflection part |
| 100 | reflective photomask blank |
| 200 | reflective photomask |

**Claims**

1. A reflective photomask blank used for manufacturing a reflective photomask for pattern transfer using an extreme ultraviolet light as a light source, the reflective photomask blank comprising:

   a substrate;
   a reflective layer containing a multi-layer film formed on the substrate; and
   an absorption layer formed on the reflective layer, wherein
   the absorption layer is formed of a material containing tin (Sn) and oxygen (O) in a proportion of 50 at% or more in total,
   an atomic number ratio (O/Sn) of oxygen (O) to tin (Sn) in the absorption layer exceeds 2.0, and

a film thickness of the absorption layer is within a range of 17 nm or more and 45 nm or less.

2. The reflective photomask blank according to claim 1, wherein the absorption layer further contains one or more elements selected from the group consisting of Ta, Pt, Te, Zr, Hf, Ti, W, Si, Cr, In, Pd, Ni, F, N, C, and H.

3. A reflective photomask comprising:

a substrate;
a reflective layer containing a multi-layer film formed on the substrate; and
an absorption pattern layer formed on the reflective layer, containing a material containing tin (Sn) and oxygen (O) in a proportion of 50 at% or more in total and having an atomic number ratio of oxygen (O) to tin (Sn) (O/Sn) of more than 2.0, on which a pattern is formed, wherein
a film thickness of the absorption pattern layer is within a range of 17 nm or more and 45 nm or less.

4. The reflective photomask according to claim 3, wherein the absorption pattern layer further contains one or more elements selected from the group consisting of Ta, Pt, Te, Zr, Hf, Ti, W, Si, Cr, In, Pd, Ni, F, N, C, and H.

FIG. 1

FIG. 2

FIG. 3

FIG. 4

FIG. 5

FIG. 6

FIG. 7

# FIG. 8

# FIG. 9

16a

x-DIRECTION LS PATTERN

y-DIRECTION LS PATTERN

128mm

64mm

64mm

128mm

EUV IRRADIATION DIRECTION
(TILTED BY 6° FROM
DIRECTION PERPENDICULAR
TO SUBSTRATE)

EUV IRRADIATION DIRECTION
(TILTED BY 6° FROM
DIRECTION PERPENDICULAR
TO SUBSTRATE)

# FIG. 10

REFLECTANCE COMPARISON

EP 4 067 994 A1

## INTERNATIONAL SEARCH REPORT

| International application No. |
|---|
| PCT/JP2020/043889 |

**A. CLASSIFICATION OF SUBJECT MATTER**
G03F 1/24(2012.01)i
FI: G03F1/24

According to International Patent Classification (IPC) or to both national classification and IPC

**B. FIELDS SEARCHED**

Minimum documentation searched (classification system followed by classification symbols)
G03F1/24

Documentation searched other than minimum documentation to the extent that such documents are included in the fields searched
Published examined utility model applications of Japan        1922–1996
Published unexamined utility model applications of Japan      1971–2021
Registered utility model specifications of Japan              1996–2021
Published registered utility model applications of Japan      1994–2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2009-088166 A (TOPPAN PRINTING CO., LTD.) 23 April 2009 (2009-04-23) paragraphs [0026], [0029]-[0030], [0037]-[0039], fig. 1-3 | 1-4 |
| X | US 2016/0124297 A1 (TAIWAN SEMICONDUCTOR MANUFACTURING COMPANY, LTD.) 05 May 2016 (2016-05-05) paragraphs [0014]-[0056], fig. 1-5 | 1-4 |
| X | KANG, Hee-Young, "Absorber stack with transparent conductive oxide layer for extreme ultraviolet lithography", J. Vac. Sci Technol. B, 12 January 2009, vol. 27, no. 1, pp. 58-60, p. 58, right column to p. 60, left column | 1-4 |

☒ Further documents are listed in the continuation of Box C.          ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 February 2021 (04.02.2021) | 16 February 2021 (16.02.2021) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2020/043889

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2013-532381 A (CARL ZEISS SMT GMBH) 15 August 2013 (2013-08-15) paragraphs [0038], [0069]-[0070], [0074] | 1-4 |
| A | US 2015/0064611 A1 (TAIWAN SEMICONDUCTOR MANUFACTURING CO., LTD.) 05 March 2015 (2015-03-05) paragraphs [0023]-[0028], fig. 2A | 1-4 |
| A | WO 2010/113700 A1 (TOPPAN PRINTING CO., LTD.) 07 October 2010 (2010-10-07) paragraphs [0095]-[0118], fig. 35-36 | 1-4 |

Form PCT/ISA/210 (continuation of second sheet) (January 2015)

**INTERNATIONAL SEARCH REPORT**
Information on patent family members

| International application No. |
| --- |
| PCT/JP2020/043889 |

| Patent Documents referred in the Report | Publication Date | Patent Family | Publication Date |
| --- | --- | --- | --- |
| JP 2009-088166 A | 23 Apr. 2009 | (Family: none) | |
| US 2016/0124297 A1 | 05 May 2016 | KR 10-2016-0051503 A TW 201627750 A CN 106154735 A | |
| JP 2013-532381 A | 15 Aug. 2013 | US 2013/0100428 A1 paragraphs [0035], [0077]-[0078] WO 2011/157643 A1 EP 2583138 A1 TW 201224643 A CN 102947759 A KR 10-2013-0087011 A | |
| US 2015/0064611 A1 | 05 Mar. 2015 | (Family: none) | |
| WO 2010/113700 A1 | 07 Oct. 2010 | US 2012/0021344 A1 paragraphs [0142]-[0168], fig. 35-36 EP 2416347 A1 KR 10-2011-0133598 A CN 102369588 A TW 201100950 A | |

Form PCT/ISA/210 (patent family annex) (January 2015)

**EP 4 067 994 A1**

**REFERENCES CITED IN THE DESCRIPTION**

**Patent documents cited in the description**

- JP 2011176162 A
- JP 2007273678 A
- JP 2011530823 A